# DEMANDE DE BREVET EUROPEEN

(11) **EP 2 511 951 A1**
(43) Date de publication de la demande: **17.10.2012**
(21) Numéro de dépôt: 12154294.8
(22) Date de dépôt: 07.02.2012
(51) Int. Cl.: H01L 21/762

(54) **Méthode de recyclage d'un substrat source**

(30) Priorité: 08.02.2011 FR 1150999
(71) Demandeur: Soitec, 38190 Bernin (FR)
(72) Inventeur: Lecomte, Monique, 38330 BIVIERS (FR); Rigal, Sophie, 38400 SAINT MARTIN D'HERES (FR); Sotta, David, 38100 GRENOBLE (FR); Janin, Fabienne, 73800 SAINTE HELENE DU LAC (FR); Veytizou, Christelle, 38190 BERNIN (FR); Guenard, Pascal, 38190 FROGES (FR)
(74) Mandataire: Collin, Jérôme

(57) **Abrégé**

La présente invention concerne un procédé de recyclage d'un substrat source (1) comprenant une région de surface (6) et des régions en relief (5) sur la région de surface (6), lesdites régions en relief (5) correspondant à des régions résiduelles d'une couche (4) du substrat source (1) non séparées du reste du substrat source (1) lors d'une l'étape préalable de prélèvement, **caractérisé en ce qu'**il comprend l'irradiation électromagnétique sélective du substrat source (1) à une longueur d'onde telle que seul le matériau endommagé de la région de surface (6) absorbe l'irradiation électromagnétique.

La présente invention concerne également un substrat source (1) recyclé et un procédé de transfert d'une couche (4) d'un substrat source (1) recyclé à cet effet.

## Description

### DOMAINE TECHNIQUE GENERAL

Le domaine de l'invention est celui des substrats semi-conducteurs utilisés dans l'industrie électronique, optique et optoélectronique.

L'invention se rapporte plus précisément au recyclage des substrats semi-conducteurs à partir desquels une couche mince de matériau a été prélevée.

### ETAT DE L'ART

Les structures SOI (Silicon-On-Insulator, Silicium sur Isolant en terminologie anglo-saxonne) sont des structures constituées d'un empilement d'une très fine couche de silicium sur une couche d'isolant, elle-même généralement sur un substrat. Ces structures sont de plus en plus utilisées dans l'industrie électronique du fait de leurs performances supérieures.

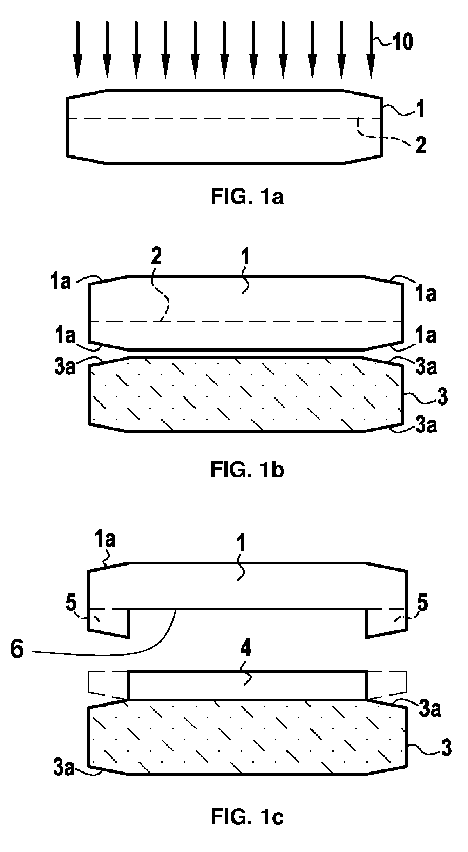

Ce type de structure est généralement réalisé selon la technologie Smart Cut™, dont les figures 1a-c en montrent les principales étapes de réalisation d'une tranche (généralement appelée «wafer» selon la terminologie anglo-saxonne) de SOI.

La figure 1a représente un substrat source 1 ou « donneur » dont une face est soumise à l'implantation par bombardement d'espèces ioniques 10 (par exemple des ions H+) de manière à créer à une certaine profondeur dans le substrat une interface de fragilisation 2. Comme illustré sur la figure 1b, on met ensuite en contact intime la face du substrat source 1 qui a subi l'implantation avec un substrat support 3 ou « receveur » de manière à réaliser un collage par adhésion moléculaire. Ce substrat support 3 peut comprendre une couche isolante en surface, cette couche isolante étant obtenue par exemple par oxydation superficielle. On réalise ensuite, comme représenté sur la figure 1c, un clivage du substrat source au niveau d'un plan médian de l'interface de fragilisation 2 pour transférer sur le substrat support 3 la partie du substrat source 1 située entre sa face externe et l'interface de fragilisation 2, la partie transférée constituant une couche 4.

Comme illustré sur la figure 1c, une « zone d'exclusion », qui correspond à une partie de la couche mince 4 non transférée, se forme à la périphérie du substrat support 1.

En effet, tel qu'illustré très schématiquement sur la figure 1b, le substrat source 1 et le substrat support 3 comportent respectivement en périphérie de leurs surfaces un chanfrein ou une "tombée de bord" 1a et 3a (également appelé « edge rounding » en terminologie anglo-saxonne) dont le rôle est de faciliter leur manipulation et d'éviter les bris de bords qui pourraient se produire si ces bords étaient saillants, de tels bris étant sources de contamination en particules des surfaces des plaques.

Cependant, la présence d'un tel chanfrein empêche un bon contact entre le substrat support 3 et le substrat source 1 au niveau de leur périphérie. La force de collage obtenue en périphérie de l'assemblage est, par conséquent, insuffisante pour retenir sur tout son diamètre la partie du substrat source 1 à transférer sur le substrat support 3. La couche 4 à transférer présente une faible épaisseur qui est limitée à plusieurs centaines de nanomètres en raison de sa formation par implantation. Cette faible épaisseur la fragilise mécaniquement, et elle se rompt au niveau du chanfrein lors du détachement. La couche 4 détachée du substrat source 1 ne se transfère donc pas à la périphérie du support, d'où une partie résiduelle qui crée une zone 5 en relief par rapport à la surface de détachement, cette zone 5 à la périphérie se présente sous la forme d'une « couronne ».

Il est nécessaire d'éliminer cette couronne si l'on veut recycler le substrat source 1 privé de la couche 4, que l'on appelle le « négatif », afin de le réutiliser en tant que « positif » pour réaliser le transfert d'une nouvelle couche mince. En outre, des zones de matériau peuvent ne pas avoir été transférées et se retrouver à la surface du négatif. On appellera dans la suite de la description de l'invention « régions en relief » l'ensemble des zones 5 en relief par rapport à la surface de détachement de façon générique, l'invention n'étant en aucune mesure limitée à la seule élimination de la couronne, même si elle représente la majeure partie des régions en relief, mais concernant également l'élimination des zones non transférées présentes en surface du négatif.

Des techniques ont été proposées pour éliminer les régions en relief 5 et permettre le recyclage du substrat source 1. Le document EP1427002 propose notamment de réaliser un polissage mécano-chimique de la surface du substrat source 1, ainsi que d'avoir recours à un jet d'eau, d'air ou de fluide, à un faisceau laser, des ondes de choc ou un bombardement ionique dirigées localement vers les régions en relief 5, en particulier en les orientant sur l'interface 2.

Toutefois, aucune de ces méthodes ne donne pleinement satisfaction. Les matériaux de certains substrats sources (SiC, GaN, AIN, AlGaN...) s'avèrent durs et sont difficiles à polir. Le polissage mécano-chimique est donc long et coûteux. Les techniques énergétiques comme l'utilisation d'un faisceau laser ne sont pas sélectives et peuvent endommager le reste du substrat source à moins d'être réglées de façon très précise.

De surcroît, les substrats présentent des diamètres de plus en plus grands (6 pouces par exemple), ce qui amplifie les difficultés citées précédemment. En particulier, des défauts, par exemple des micro-rayures, risquent de se former.

### PRESENTATION DE L'INVENTION

La présente invention vise à faciliter l'élimination de la couronne de matière résiduelle sur un substrat donneur, et donc d'en favoriser le recyclage, en diminuant tant la durée et la qualité que le coût des opérations de recyclage.

A cet effet, la présente invention se rapporte selon un premier aspect à un procédé de recyclage d'un substrat source comprenant une région de surface et des régions en relief sur la région de surface, lesdites régions en relief correspondant à des régions résiduelles d'une couche du substrat source non séparées du reste du substrat source lors d'une l'étape préalable de prélèvement mettant en oeuvre une séparation au niveau d'une interface de fragilisation constituée de matériau endommagé du substrat source, la région de surface correspondant à une partie de l'interface de fragilisation non séparée du reste du substrat source lors de l'étape préalable de prélèvement, **caractérisé en ce qu'**il comprend l'irradiation électromagnétique sélective du substrat source à une longueur d'onde telle que seul le matériau endommagé de la région de surface absorbe l'irradiation électromagnétique.

Il est ainsi possible d'effectuer une irradiation électromagnétique à une longueur d'onde déterminée sur l'ensemble de la surface du substrat source à recycler, seul le matériau endommagé situé à la base de la couronne ou des régions non transférées en relief absorbera et sera alors éliminé de façon sélective. La puissance du rayonnement est ainsi choisie de façon à ce que l'échauffement du matériau à éliminer n'endommage pas les zones avoisinantes, d'où un état optimal du substrat source en fin de recyclage.

Selon d'autres caractéristiques avantageuses et non limitatives :
- les régions en relief correspondent à une couronne de matériau de la couche du substrat source et/ou à des zones non transférées de matériau de la couche du substrat source reparties aléatoirement sur la région de surface ;
- l'irradiation électromagnétique sélective s'effectue sur l'ensemble de la surface du substrat source ;
- l'irradiation électromagnétique sélective est asservie par un dispositif optique détectant les régions en relief pour s'effectuer localement sur les régions en relief ;
- ledit dispositif optique détecte les régions en relief par différence de contraste optique entre le matériau endommagé de l'interface de fragilisation et le matériau non endommagé du substrat source ;
- le substrat source est constitué d'un matériau massif choisi parmi au moins un des matériaux suivants : SiC, un matériau III/N binaire, ternaire ou quaternaire ; ou est constitué d'une structure composite de type GaNOS, InGaNOS, SiCOI, SiCopSiC ;
- l'interface de fragilisation est générée par implantation d'espèces ioniques dans le substrat source ;
- le procédé comprend la mise en oeuvre d'un polissage mécano-chimique de la région de surface du substrat source suite à l'irradiation électromagnétique sélective ;
- ledit polissage mécano-chimique utilise une solution colloïdale acide enrichie d'un additif, en particulier de particules de diamant et/ou un oxydant ;
- l'irradiation électromagnétique sélective du substrat source est réalisée au moyen d'un laser ;
- le matériau du substrat source est du GaN et le laser émet à une longueur d'onde supérieure ou égale à 370 nm ;
- le matériau du substrat source est du SiC et le laser émet à une longueur d'onde supérieure ou égale à 415 nm ;
- le laser est un laser au grenat d'yttrium-aluminium en mode pulsé ;
- le laser a une fluence de 0.1 à 2 J/cm² ;
- le procédé comprend la mise en oeuvre d'une épitaxie d'au moins une couche de matériau sur une surface du substrat source ;
- ladite épitaxie de matériau est réalisée sur la surface mise à jour suite à l'irradiation électromagnétique sélective.

Selon un deuxième aspect, l'invention concerne un substrat source recyclé par un procédé selon le premier aspect de l'invention pour être réutilisé.

L'invention concerne enfin selon un troisième aspect un procédé de transfert d'une couche d'un substrat source recyclé selon le deuxième aspect de l'invention vers un substrat support comprenant des étapes de :
- génération d'une interface de fragilisation dans le substrat source recyclé à une profondeur délimitant l'épaisseur de la couche ;
- mise en contact du substrat source recyclé et d'un substrat support ;
- traitement thermique de fracture.

### PRESENTATION DES FIGURES

D'autres caractéristiques et avantages de la présente invention apparaîtront à la lecture de la description qui va suivre d'un mode de réalisation préférentiel. Cette description sera donnée en référence aux dessins annexés dans lesquels :
- les figures 1a-c déjà décrites sont des schémas illustrant les principales étapes du procédé Smart Cut™ et expliquant la formation d'une couronne;
- la figure 2 est un diagramme représentant les étapes d'un mode de réalisation d'un procédé de recyclage selon l'invention associé à un procédé de transfert;
- la figure 3 est un schéma représentant en détail une région résiduelle.

### DESCRIPTION DETAILLEE

L'invention repose sur le fait que la fragilisation du matériau constitutif d'un substrat source 1 endommage sa structure cristalline jusqu'à singulièrement modifier son spectre de transmission optique. Les bandes du spectre dans lesquelles le matériau est transparent à un rayonnement, ou au contraire l'absorbe, se déplacent effectivement du fait de l'endommagement de la structure cristalline. L'invention propose d'une manière générale d'avoir recours à une irradiation électromagnétique du substrat à recycler à une longueur d'onde à laquelle le matériau endommagé absorbe tandis que le matériau dont la maille cristalline est peu ou pas endommagée n'absorbe pas ou nettement moins.

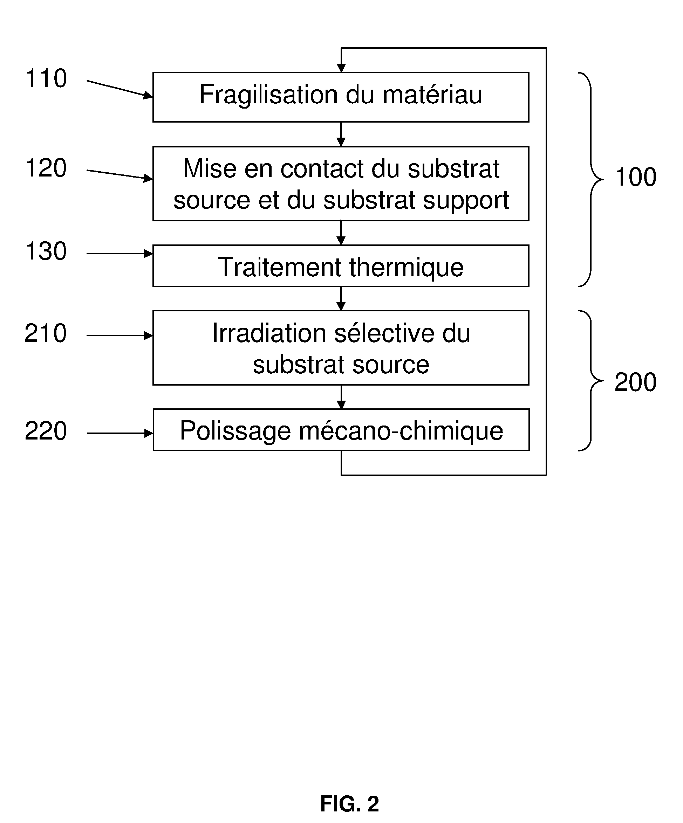

Comme expliqué précédemment, et comme représenté sur la figure 2, le procédé 200 de recyclage d'un substrat source 1 selon l'invention suit un procédé 100 préalable de séparation d'une couche 4 d'un substrat source 1, ce procédé 100 comprenant avantageusement le transfert d'une couche 4 du substrat source 1 vers un substrat support 3.

L'invention n'est toutefois pas limitée à un tel transfert, mais vise de manière plus générale toute séparation d'une couche 4 suite à la fragilisation du substrat source 1, notamment par implantation d'espèces ioniques. Par ailleurs, le substrat support 3 agissant comme raidisseur mécanique de la couche 4, il peut non seulement être collé sur la couche 4 avant séparation mais peut être également déposé sur la couche 4 par toute méthode de dépôt, typiquement par épitaxie. En outre, la couche 4 peut présenter une épaisseur et une rigidité mécanique suffisante pour être autoportée (il est possible de la manipuler sans qu'elle s'enroule sur elle-même ou sans qu'elle se casse) ou au moins être utilisable sans la nécessité d'un raidisseur mécanique extérieur. Ainsi, en absence de substrat mécanique 3, on parle de séparation ou détachement de la couche 4 et non de transfert.

Suite à ce procédé 100 préalable, le négatif, c'est-à-dire le substrat source 1 privé de la couche 4 transférée, comprend des régions en relief 5 en relief par rapport à une région de surface 6, ces régions en relief 5 étant des régions résiduelles de la couche 4, et sont donc composées de matière résiduelle de la couche 4.

On notera que l'on parle d'une « région de surface », et non seulement d'une surface. Ce point sera clarifié plus loin dans la présente description.

Avantageusement, le substrat source 1 est constitué d'un matériau choisi parmi au moins un des matériaux suivants : SiC, un matériau III/N binaire, ternaire, ou quaternaire tel que le GaN, AlN, AlGaN, InGaN. Le substrat source 1 peut également être constitué d'une structure composite comprenant un support mécanique sur lequel une couche de matériau parmi la liste ci-dessus a été collée. Typiquement la structure composite peut être un SiCopSiC (couche de SiC collée sur un substrat en SiC polycristallin), ou un GaNOS (couche de GaN collée sur un substrat de saphir). Le substrat source 1 peut également être structure composite sur laquelle une couche a été déposée, c'est le cas de l'InGaNOS pour lequel une couche d'InGAN a été déposée par épitaxie sur une structure GaNOS. Le substrat support 3 est constitué d'un matériau choisi parmi au moins un des matériaux suivants : AIN, GaN, SiC, du saphir, une céramique, un alliage métallique. L'invention n'est toutefois limitée à aucune combinaison de matériau en particulier.

### Etapes des procédés de transfert et de recyclage

Le procédé 100 préalable de séparation consiste avantageusement dans le cas d'un procédé de transfert en la séparation du substrat source 1 au niveau d'une interface de fragilisation 2 formée d'un matériau endommagé séparant la couche 4 du reste du substrat source 1.

Dans ce cas, le procédé 100 de transfert comprend de façon particulièrement avantageuse trois étapes. Tout d'abord l'interface 2 est créée par une étape 110 de fragilisation du matériau. Avantageusement, cette étape consiste en une implantation d'espèces ioniques. La surface du substrat 1 est bombardée par un faisceau d'espèces ioniques à une énergie et une dose déterminées. Ceux-ci pénètrent dans le matériau à une profondeur prédéterminée qui conditionne l'épaisseur de la couche 4.

Une fois l'interface de fragilisation 2 générée, le substrat source 1 et le substrat support 3 sont mis en contact lors d'une seconde étape 120 pour un collage par adhésion moléculaire. Préalablement à cette étape, des oxydations du substrat source 1 et/ou du substrat support 1 peuvent optionnellement être mises en oeuvre. Selon la nature du matériau, et notamment dans le cas des matériaux III/N, saphir, SiC , il peut être procédé à un dépôt d'une couche de dioxyde de silicium SiO₂ ou de nitrure de silicium SixNy qui participe à augmenter l'énergie de collage entre les surfaces mises en contact.

Un traitement thermique 130 de fracture vient terminer le procédé de transfert. Par une élévation de température, le collage entre les deux substrats 1 et 3 est renforcé, tandis qu'une fracture au niveau de la zone implantée (l'interface de fragilisation 2) est provoquée. La couche 4 se détache du substrat 1, excepté sur la périphérie et sur d'autres régions aléatoirement réparties à la surface du substrat, le tout formant les régions en relief 5.

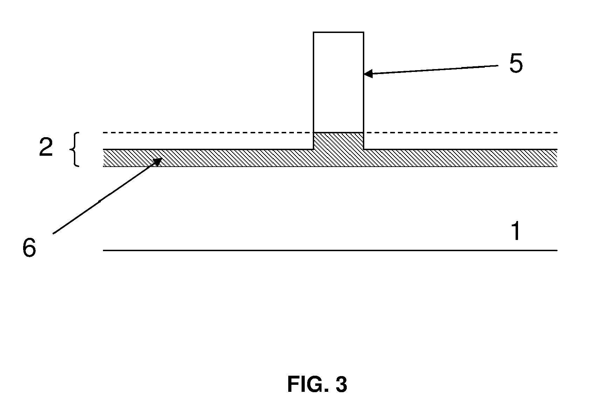

Il est important d'observer que l'interface de fragilisation 2 est en fait une région en volume, comme on peut le voir sur la représentation schématique de la figure 3. L'interface de fragilisation 2 présente en réalité une épaisseur qui correspond à la plus on moins profonde pénétration des espèces ioniques lors du bombardement. En effet, bien qu'implantées avec grande précision dans le substrat source 1, les espèces ioniques se répartissent en fait sur une étroite bande avec un pic en son plan médian, globalement selon une gaussienne, ce qui fait que l'interface de fragilisation 2 est un volume de matériau endommagé et non un plan, l'endommagement étant maximal au niveau du plan médian.

Le plan de fracturation selon lequel la couche 4 se détache du substrat 1 se situe donc au niveau de ce plan médian, dans l'épaisseur de l'interface de fragilisation 2 : une partie de l'interface de fragilisation 2 se retrouve donc sur chacune des surfaces de la couche 4 et du substrat 1.

Ainsi, la région de surface 6 désigne la partie de l'interface de fragilisation 2 non séparée du reste du substrat source 1, cette partie consistant en une couche de matériau endommagé d'épaisseur variable se retrouvant sur toute la surface du substrat source 1 comme on peut le voir sur la figure 3.

Ainsi, étant toujours attachées au négatif du substrat 1, les régions en relief 5 possèdent à leur base l'épaisseur complète de l'interface de fragilisation 2.

L'absorption de l'irradiation électromagnétique par le matériau endommagé qui constitue les restes de l'interface de fragilisation 2, permet l'élimination de la région de surface 6 et donc le détachement de la région résiduelle 5 du substrat source 1.

L'implantation d'espèces ioniques dans un matériau endommage en effet la structure cristalline de celui-ci par création de défauts variés jusqu'à amorphiser le matériau, ce qui modifie son spectre d'absorption optique. Le procédé 200 de recyclage selon l'invention comprend ainsi au moins une sous-étape 210 d'irradiation électromagnétique du substrat source 1.

En effectuant une irradiation électromagnétique sélective à une longueur d'onde déterminée, seul le matériau endommagé de l'interface 2 absorbera l'énergie du rayonnement et sera transformé de façon sélective, la transformation étant de façon avantageuse une destruction due à un échauffement important. Le reste du matériau est transparent au rayonnement et sera tout simplement traversé sans être modifié. Or comme expliqué les parties résiduelles de l'interface 2 constituent la région de surface 6 et se trouvent en particulier interposées entre les régions en relief 5 et le reste du substrat source 1.

La puissance du rayonnement peut être choisie de façon à ce que l'échauffement du matériau à éliminer n'endommage pas les zones avoisinantes. Il est en outre possible d'utiliser toutes espèces ioniques permettant la fracture du matériau implanté tel que l'hydrogène et/ou l'hélium couramment utilisés.

Avantageusement, l'irradiation électromagnétique sélective se fait sur l'ensemble de la surface du négatif à recycler, indifféremment de l'inclinaison et de la position de la source, qui est préférentiellement un laser. Un balayage de l'irradiation sur la tranche du substrat peut également être mis en oeuvre ce qui peut être utile dans le cas de prélèvement de couche par implantation à partir d'un lingot. Il n'y a plus besoin d'orienter un faisceau précisément à l'interface entre les régions en relief 5 et la région de surface 6 comme cela pouvait être le cas dans certains procédés de recyclage de l'art antérieur. Pour cela, le laser est mis en mouvement afin de balayer au moins une fois la totalité de la surface du substrat source 1. Comme le matériau non endommagé est transparent à l'irradiation à la longueur d'onde choisie, il est possible d'irradier plusieurs fois des portions de la surface du substrat source 1.

Alternativement, l'irradiation électromagnétique sélective s'effectue localement sur les régions en relief 5 sous le contrôle d'un dispositif optique détectant les régions en relief 5. En effet, puisque le matériau endommagé de l'interface de fragilisation 2 et le matériau non endommagé du substrat source 1 présentent une différence d'absorption optique, il est possible de repérer visuellement par différence de contraste optique les zones de la surface du substrat source 1 au niveau desquelles l'épaisseur de matériau endommagé est plus importante qu'ailleurs : comme l'on voit sur la figure 3, ces zones sont situées à la base des régions en relief 5.

Ainsi, le dispositif optique, qui peut être une simple caméra vidéo, détecte avantageusement les régions en relief 5 grâce à ce principe.

En couplant un tel dispositif optique au laser, il est possible d'asservir ce dernier de façon à ce qu'il n'émette l'irradiation électromagnétique sélective que lorsqu'il vise des zones en relief 5. Ce mode de réalisation permet à faible coût des économies de temps et d'énergie, puisque le laser est activé bien moins longtemps.

Pour les matériaux III/N et en particulier pour le GaN, qui absorbe quand il est endommagé à partir d'une longueur d'onde de 370 nm, ou pour le SiC qui absorbe quand il est endommagé à partir d'une longueur d'onde de 415 nm, des lasers de type YAG doublé au grenat d'yttrium-aluminium en mode pulsé configurés pour émettre à une longueur d'onde de 532 nm et/ou avec une fluence de 0.1 à 2 J/cm² sont préférés. Il est également possible d'utiliser un laser Argon qui émet une longueur d'onde de 488 nm et de 514 nm. L'homme de l'art saura choisir différents types de laser afin d'adapter la longueur d'onde et la fluence de l'émission à tout type de substrat source 1 implanté.

Avantageusement, le procédé 200 de recyclage comprend une seconde sous-étape 220 de polissage mécano-chimique, connu sous l'acronyme CMP (Chemical-Mecanical Polishing), après l'irradiation électromagnétique sélective.

Cette sous-étape 220 permet de finaliser le recyclage du substrat source 1, par le traitement de la région de surface 6 une fois les régions en relief 5 éliminées, cela afin d'atteindre une topologie de surface adaptée à une nouvelle utilisation du substrat source 1 en tant que substrat donneur d'une nouvelle couche mince 4. Le détachement de cette nouvelle couche 4 peut être effectué après une étape de dépôt de matériau sur le substrat ainsi obtenu, afin de renouveler le matériau prélevé et régénérer l'épaisseur initiale du substrat source. Ce dépôt peut être effectué sur la surface recyclée du négatif (c'est-à-dire la surface mise à jour par l'irradiation électromagnétique sélective, éventuellement traitée par CMP) comme sur la face opposée, appelée face arrière. La couche 4 n'étant pas prélevée en face arrière, la qualité du matériau importe peu et les conditions de dépôt sont moins contrôlées. Lorsqu'au contraire, le matériau déposé formera la nouvelle couche 4, la méthode de dépôt utilisée sera de préférence une épitaxie par MBE (« Molecular Beam Epitaxy », c'est-à-dire Epitaxie par jet moléculaire), MOCVD (« Metalorganic Chemical Vapor Deposition », c'est-à-dire Dépôt chimique en phase vapeur aux organométalliques) ou HVPE (« Hydride Vapor Phase Epitaxy », c'est-à-dire Epitaxie en phase vapeur par la méthode aux hydrures) pour conduire à l'obtention d'un matériau d'une belle qualité cristalline.

Le polissage CMP consiste en un polissage hybride par la combinaison d'une action chimique et d'une force mécanique. Un tissu, le « pad » est appliqué avec pression sur la surface en rotation du matériau.

Une solution chimique, le « slurry », avantageusement contenant des microparticules en suspension, typiquement des colloïdes, est appliquée sur le matériau. Le slurry vient circuler entre la surface et le pad et décuple l'efficacité du polissage.

Préférentiellement, le polissage CMP de l'étape 220 utilise un slurry comprenant une solution colloïdale acide enrichie de particules de diamant et/ou d'un oxydant.

L'invention concerne en outre un substrat source 1 recyclé par un tel procédé 200, et à présent apte à être réemployé pour un nouveau procédé de transfert d'une couche 4 vers un substrat support 3 comprenant encore des étapes de :
- génération de l'interface de fragilisation 2 dans le substrat source 1 recyclé à une profondeur délimitant l'épaisseur de la couche 4 ;
- mise en contact du substrat source 1 recyclé et d'un substrat support 3 ;
- traitement thermique de fracture.

Il est envisageable de réaliser plusieurs cycles de transfert puis recyclage d'un substrat source 1, notamment tant que l'épaisseur du substrat source est suffisante pour qu'il présente la résistance mécanique nécessaire à sa manipulation et la compatibilité nécessaire pour une utilisation avec des outils de production. Par ailleurs, il est possible comme expliqué précédemment de reformer le matériau prélevé sur le négatif recyclé, par épitaxie par exemple, afin de conserver une épaisseur constante de substrat source. Un dépôt de matériau sur la face opposée à celle utilisée pour le prélèvement peut également être réalisé.

### Exemple

Sur un substrat source 1 autoporté de GaN est déposée une couche d'oxyde de silicium d'une épaisseur de 500 nm. Une implantation d'hydrogène avec une dose supérieure à 1.10^{e}16 atomes/cm² et une énergie de 50 à 150 KeV selon l'épaisseur de couche 4 à transférer est réalisée dans le GaN à travers la couche d'oxyde. Ceci conduit à une concentration d'espèces moyennes d'environ 1.10^{e}21 atomes/cm³ à proximité de l'interface de fragilisation 2 et le matériau devient absorbant à une longueur d'onde supérieure ou égale à 370 nm. Par ailleurs, une couche de 500 nm d'oxyde de silicium est déposée sur un substrat support 3 de saphir.

Les substrats de GaN et de saphir sont alors mis en contact pour un collage. Leurs surfaces peuvent être polies juste avant cette étape de mise en contact ; il est en effet souhaitable que la rugosité de surface soit inférieure à 5 Angstrom RMS mesuré par AFM, c'est-à-dire microscope à force atomique (Atomic Field Microscope en terminologie anglo-saxonne) sur un champ de 5x5 microns (ce champ correspond à la taille de la zone observée).

La rugosité RMS signifie rugosité « Root Mean Square ». Il s'agit d'une mesure consistant à mesurer la valeur de l'écart quadratique moyen de la rugosité. Cette rugosité RMS, concrètement, quantifie donc en moyenne la hauteur des pics et creux de rugosité, par rapport à la hauteur moyenne. Cette rugosité est également contrôlée par AFM.

Une fois la mise en contact réalisée, un traitement thermique avec une rampe de température de 200 à 700°C est effectué pour renforcer le collage et provoquer la fracture au niveau de la zone implantée. Le négatif est récupéré et le recyclage commence.

La couronne et les zones non transférées à la surface du négatif du substrat source 1 de GaN sont alors éliminées par irradiation de l'ensemble de la surface du substrat source à recycler à une longueur d'onde de 532 nm avec un laser de type « YAG doublé », qui est un laser au grenat d'yttrium-aluminium utilisé en mode pulsé, avec une fluence de 0.1 à 2 Joules/cm². Le GaN non implanté, dont la maille cristalline n'est pas endommagée, absorbe à une longueur d'onde inférieure à 365 nm. L'absorption de l'irradiation du négatif substrat source à 532 nm est donc sélective.

Un polissage mécano-chimique CMP parfait le recyclage, une solution colloïdale acide pourvue d'un additif tel que des particules de diamants et/ou un oxydant peut être utilisée. De manière à pouvoir utiliser ce substrat de la même façon que le substrat initial, il est nécessaire de polir jusqu'à obtenir des rayures de moins de 15 nm de profondeur et une rugosité inférieure à 5 Angstrom RMS en 20x20 microns par AFM.

Ce substrat peut être de nouveau utilisé directement dans un procédé de détachement de couche mais peut également servir de germe pour l'épitaxie d'un nouveau matériau et restaurer l'épaisseur du substrat initial avant d'être utilisé dans le détachement d'une nouvelle couche.

## Revendications

1. Procédé de recyclage d'un substrat source (1) comprenant une région de surface (6) et des régions en relief (5) sur la région de surface (6), lesdites régions en relief (5) correspondant à des régions résiduelles d'une couche (4) du substrat source (1) non séparées du reste du substrat source (1) lors d'une l'étape préalable de prélèvement mettant en oeuvre une séparation au niveau d'une interface de fragilisation (2) constituée de matériau endommagé du substrat source (1), la région de surface (6) correspondant à une partie de l'interface de fragilisation (2) non séparée du reste du substrat source (1) lors de l'étape préalable de prélèvement,
**caractérisé en ce qu'**il comprend l'irradiation électromagnétique sélective du substrat source (1) à une longueur d'onde telle que seul le matériau endommagé de la région de surface (6) absorbe l'irradiation électromagnétique.

2. Procédé selon la revendication 1, dans lequel les régions en relief (5) correspondent à une couronne de matériau de la couche (4) du substrat source (1) et/ou à des zones non transférées de matériau de la couche (4) du substrat source (1) reparties aléatoirement sur la région de surface (6).

3. Procédé selon l'une des revendications 1 à 2, dans lequel l'irradiation électromagnétique sélective s'effectue sur l'ensemble de la surface du substrat source (1).

4. Procédé selon l'une des revendications 1 à 2, dans lequel l'irradiation électromagnétique sélective est asservie par un dispositif optique détectant les régions en relief (5) pour s'effectuer localement sur les régions en relief (5).

5. Procédé selon la revendication 4, dans lequel ledit dispositif optique détecte les régions en relief (5) par différence de contraste optique entre le matériau endommagé de l'interface de fragilisation (2) et le matériau non endommagé du substrat source (1).

6. Procédé selon l'une des revendications précédentes, dans lequel le substrat source (1) est constitué d'un matériau massif choisi parmi au moins un des matériaux suivants : SiC, un matériau III/N binaire, ternaire ou quaternaire; ou est constitué d'une structure composite de type GaNOS, InGaNOS, SiCOI, SiCopSiC.

7. Procédé selon l'une des revendications précédentes, dans lequel l'interface de fragilisation (2) est générée par implantation d'espèces ioniques (10) dans le substrat source (1).

8. Procédé selon l'une des revendications précédentes, comprenant la mise en oeuvre d'un polissage mécano-chimique de la région de surface (6) du substrat source (1) suite à l'irradiation électromagnétique sélective.

9. Procédé selon la revendication 8, **caractérisé en ce que** ledit polissage mécano-chimique utilise une solution colloïdale acide enrichie d'un additif, en particulier de particules de diamant et/ou un oxydant.

10. Procédé selon l'une des revendications précédentes, dans lequel l'irradiation électromagnétique sélective du substrat source (1) est réalisée au moyen d'un laser.

11. Procédé selon la revendication 10, dans lequel le matériau du substrat source (1) est du GaN et le laser émet à une longueur d'onde supérieure ou égale à 370 nm.

12. Procédé selon la revendication 10, dans lequel le matériau du substrat source (1) est du SiC et le laser émet à une longueur d'onde supérieure ou égale à 415 nm.

13. Procédé selon l'une des revendications 10 à 12, dans lequel le laser est un laser au grenat d'yttrium-aluminium en mode pulsé.

14. Procédé selon la revendication 13, dans lequel le laser a une fluence de 0.1 à 2 J/cm².

15. Procédé selon l'une des revendications précédentes, comprenant la mise en oeuvre d'une épitaxie d'au moins une couche de matériau sur une surface du substrat source (1).

16. Procédé selon la revendication précédente, dans lequel ladite épitaxie de matériau est réalisée sur la surface mise à jour suite à l'irradiation électromagnétique sélective.

17. Substrat source (1) recyclé par un procédé selon l'une des revendications précédentes pour être réutilisé.

18. Procédé de transfert d'une couche (4) d'un substrat source (1) recyclé selon la revendication 13 vers un substrat support (3) comprenant des étapes de :
- génération d'une interface de fragilisation (2) dans le substrat source (1) recyclé à une profondeur délimitant l'épaisseur de la couche (4) ;
- mise en contact du substrat source (1) recyclé et d'un substrat support (3) ;
- traitement thermique de fracture.
